(19) Europäisches Patentamt
European Patent Office
Office européen des brevets

(11) **EP 2 016 428 B1**

(12) **EUROPÄISCHE PATENTSCHRIFT**

(45) Veröffentlichungstag und Bekanntmachung des Hinweises auf die Patenterteilung:
**01.11.2017 Patentblatt 2017/44**

(21) Anmeldenummer: **07724390.5**

(22) Anmeldetag: **19.04.2007**

(51) Int Cl.:
*G01D 3/032* *(2006.01)*  *G01R 13/02* *(2006.01)*

(86) Internationale Anmeldenummer:
**PCT/EP2007/003453**

(87) Internationale Veröffentlichungsnummer:
**WO 2007/128392 (15.11.2007 Gazette 2007/46)**

(54) **VERFAHREN UND VORRICHTUNG ZUR DIGITALEN TRIGGERUNG EINES MIT EINEM RAUSCHSIGNAL ÜBERLAGERTEN MESSSIGNALS**

METHOD AND APPARATUS FOR DIGITALLY TRIGGERING A MEASUREMENT SIGNAL HAVING A SUPERIMPOSED NOISE SIGNAL

PROCÉDÉ ET DISPOSITIF DE DÉCLENCEMENT NUMÉRIQUE D'UN SIGNAL DE MESURE À SIGNAL DE BRUIT SUPERPOSÉ

(84) Benannte Vertragsstaaten:
**DE FR GB**

(30) Priorität: **05.05.2006 DE 102006021075**

(43) Veröffentlichungstag der Anmeldung:
**21.01.2009 Patentblatt 2009/04**

(73) Patentinhaber: **Rohde & Schwarz GmbH & Co. KG**
**81671 München (DE)**

(72) Erfinder:
• **KUHWALD, Thomas**
**83623 Dietramszell (DE)**
• **HUBER, Johann**
**85570 Markt Schwaben (DE)**
• **FREIDHOF, Markus**
**85614 Kirchseeon (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
JP-A- 7 234 250      US-A- 3 704 416
US-A1- 2003 128 021      US-A1- 2006 074 607

• ANONYMOUS: "Application Note: HFAN-4.3.0, Jitter Specifications Made Easy"[Online] 6. Februar 2001 (2001-02-06), Seiten 1-6, XP002461833 Gefunden im Internet: URL:http://pdfserv.maxim-ic.com/en/an/AN377.pdf> [gefunden am 2007-12-06]
• R.L.JUNGERMAN, P.SAMRA: "Switched-radar scenarion generation with Femtosecond jitter"[Online] August 2005 (2005-08), Seiten 18-22, XP002461834 Gefunden im Internet: URL:http://rfdesign.com/mag/508RFDSF2.pdf> [gefunden am 2007-12-06]
• DESROCHERS E: "LOWPASS FILTER DISCRIMINATES STEP INPUT FROM NOISE", EDN ELECTRICAL DESIGN NEWS.(TEXAS INSTRUMENT),REED BUSINESS INFORMATION, HIGHLANDS RANCH, CO, US, vol. 48, no. 20, 18 September 2003 (2003-09-18), page 92,96, XP001177659, ISSN: 0012-7515
• JUNGERMAN R L ET AL: "Switched-radar scenarion generation with Femtosecond jitter", INTERNET CITATION, August 2005 (2005-08), XP002461834, Retrieved from the Internet: URL:http://rfdesign.com/mag/508RFDSF2.pdf [retrieved on 2007-12-11]

EP 2 016 428 B1

**Beschreibung**

Die Erfindung betrifft ein Verfahren und eine Vorrichtung zur digitalen Triggerung einer Aufzeichnung eines mit einem Rauschsignal überlagerten Referenzsignals.

Zur phasen- bzw. zeitkorrekten Darstellung eines Messsignals auf einem Aufzeichnungsgerät, beispielsweise einem digitalen Oszilloskop, ist eine Triggerung erforderlich, die beispielsweise über einen Triggerschwellwert den auf dem Aufzeichnungsgerät darzustellenden Signalabschnitt des Messsignals identifiziert und über ein daraus abgeleitetes Triggersignal zum Triggerzeitpunkt die Aufzeichnung des Messsignals auf dem Aufzeichnungsgerät initiiert. Die US 2006/0074607 A1 (WELLER DENNIS J, 6. April 2006) beschreibt eine Vorrichtung zur digitalen Triggerung einer Aufzeichnung in einem digitalen Echtzeit Oszilloskop. Die Vorrichtung zur digitalen Triggerung verfügt über einen zuschaltbare Tiefpassfilter zur Bandbegrenzung des Messsignal mit zwei Ausgängen, deren jeweilige Grenzfrequenz festgelegt ist. Aus dem bandbegrenzten Messsignal wird ein Triggersignal erzeugt.

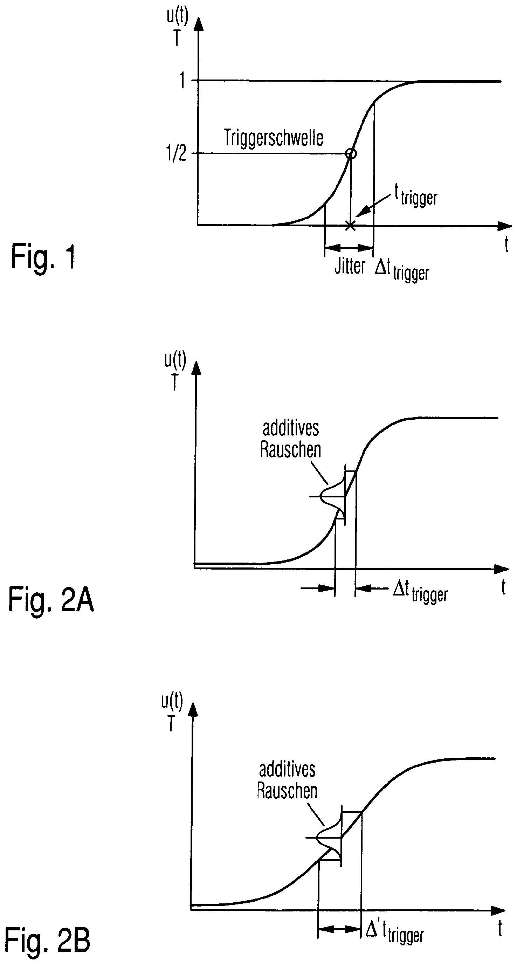

Ist dem Messsignal ein Rauschsignal überlagert, das einem mittelwertfreien, weißen Rauschen mit der Varianz $\sigma_n^2$ entspricht, so liegt kein fester Triggerzeitpunkt $t_{trigger}$ wie bei einem rauschfreien Messsignal, sondern gemäß Fig. 1 ein Jittern des Triggerzeitpunkts $t_{trigger}$ mit einer von der Varianz $\sigma_n^2$ des Rauschsignals abhängigen Varianz $\sigma_t^2$ vor. Für den Triggerzeitpunkt $t_{trigger}$ eines rauschfreien Messsignals ergibt sich ausgehend von Fig. 1 und der daraus abgeleiteten Triggergleichung (1) mit einem Triggerschwellwert $u_T$ von 1/2 und einer Flankensteilheit $m$ des Messsignals ein fester Wert entsprechend Gleichung (2).

$$u_T = m \cdot t_{trigger} \qquad\qquad (1)$$

$$t_{trigger} = \frac{1}{2 \cdot m} \qquad\qquad (2)$$

Ist dem Messsignal ein Rauschsignal n mit einer Varianz $\sigma_n^2$ überlagert so ergibt sich ausgehend von der Triggergleichung (3) bei einem Triggerschwellwert $u_T$ von 1/2 und einer Flankensteilheit $m$ des Messsignals ein jitternder Triggerzeitpunkt $t_{trigger}$ gemäß Gleichung (4) mit einem Mittelwert von $\dfrac{1}{2 \cdot m}$ und einer Varianz $\sigma_t^2$ gemäß Gleichung (5).

$$u_T = m \cdot t_{trigger} + n \qquad\qquad (3)$$

$$t_{trigger} = \frac{1}{2 \cdot m} - \frac{n}{2} \qquad\qquad (4)$$

$$\sigma_t^2 = \frac{\sigma_n^2}{n^2} \qquad\qquad (5)$$

Aus Gleichung (5) ist ersichtlich, dass die Varianz $\sigma_t^2$ des Jitterns des Triggerzeitpunkts bei einem mit einem Rauschsignal überlagerten Messsignal bei einem zunehmend flacheren Anstieg $m$ des Messsignals zunimmt. Während bei einem hochfrequenten Messsignal mit einer hohen Flankensteilheit $m$ die Varianz $\sigma_t^2$ des Jitterns des Triggerzeit- punkts gemäß Fig. 2A vergleichsweise gering ist, ist die Varianz $\sigma_t^2$ des Jitterns des Triggerzeitpunkts bei einem niederfrequenten Messsignal mit einer niedrigen Flankensteilheit $m$ gemäß Fig. 2B deutlich höher und nicht mehr zu vernachlässigen.

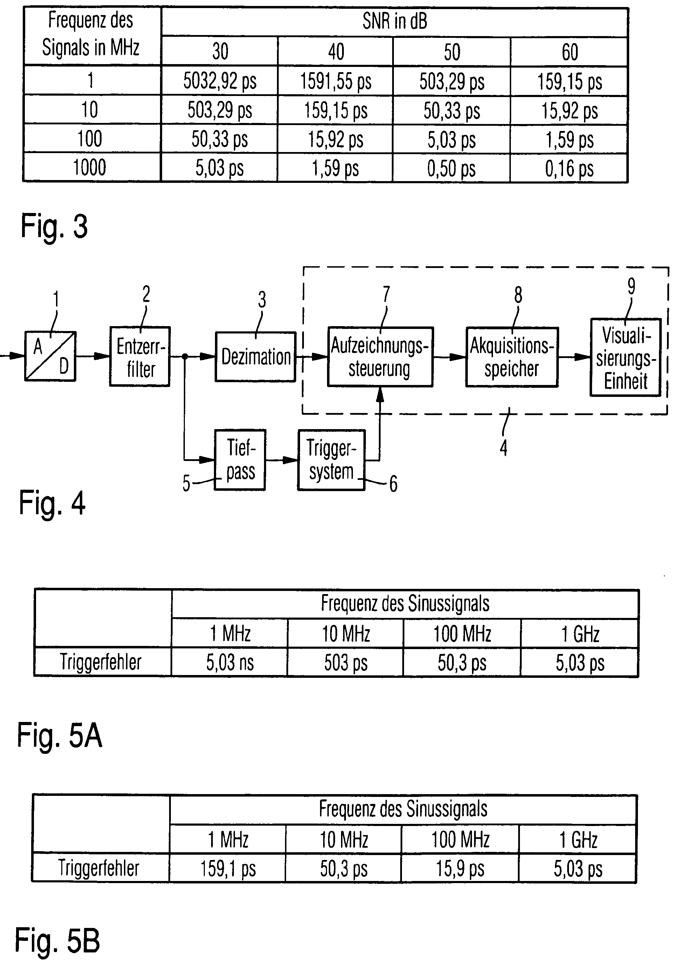

Aus Tabelle 1 in Fig. 3 ist ersichtlich, dass mit abnehmender Frequenz des Messsignals und damit abnehmender Flankensteilheit $m$ und gleichzeitig abnehmendem Signal-Rausch-Abstand (SNR) und somit zunehmendem Rauschsignalanteil am Messsignal die Varianz $\sigma_t^2$ des Jitterns des Triggersignals und damit die Triggerungenauigkeit zunimmt.

In der Druckschrift DE 34 18 500 A1 wird eine Vorrichtung und ein Verfahren beschrieben, bei dem der Nachteil des Jitterns des Triggerzeitpunkts und damit der Triggerungenauigkeit infolge eines dem Messsignal überlagerten Rauschens dadurch gelöst wird, dass die Pegeltriggerung in eine dazu proportionale Zeittriggerung umgewandelt wird und in Abhängigkeit der Bandbreite des Messsignals und der Bandbreite des Rauschsignal ein geeigneter Schwellwert für die Zeittriggerung einstellbar ist.

Nachteilig an einer derartigen Realisierung ist der vergleichsweise hohe schaltungstechnische Aufwand (Detektion des Nulldurchgangs, Generierung der Kippspannung, Initialisierung der Kippspannung und Detektion des Sollwertdurchgangs).

Aufgabe der Erfindung ist es deshalb, ein Verfahren und eine Vorrichtung für eine digitale Triggerung zu entwickkeln, mit der die Triggerungenauigkeit bei einem mit einem Rauschsignal überlagerten Messsignal, insbesondere im Fall eines niederfrequenten Messsignals, aufwandsarm minimiert wird.

Die Aufgabe wird durch eine Vorrichtung zur digitalen Triggerung mit den Merkmalen des Anspruchs 1 und durch ein Verfahren zur digitalen Triggerung mit den Merkmalen des Anspruchs 2 gelöst.

Erfindungsgemäß wird der digitalen Triggerung eine Tiefpassfilterung vorgelagert, die die Bandbreite des mit einem Rauschsignal überlagerten Messsignals reduziert. Auf diese Weise wird die Varianz $\sigma_n^2$ des Rauschsignals reduziert, was zu einer Minimierung des Triggerfehlers führt.

Das erfindungsgemäße Verfahren und die erfindungsgemäße Vorrichtung zur digitalen Triggerung einer Aufzeichnung eines mit einem Rauschsignal überlagerten Messsignals wird im Folgenden anhand der Zeichnung im Detail erläutert. Die Figuren der Zeichnung zeigen:

Fig. 1   eine zeitliche Darstellung einer Triggerschwelle eines mit einem Rauschsignal überlagerten Messsignals,

Fig. 2A, 2B   eine zeitliche Darstellung einer Triggerschwelle eines mit einem Rauschsignal überlagerten hochfrequenten und niederfrequenten Messsignals,

Fig. 3   eine Tabelle mit Triggerfehlern in Abhängigkeit des Signalrauschabstands und der Frequenz des Messsignals,

Fig. 4   ein Blockschaltbild der erfindungsgemäßen Vorrichtung zur digitalen Triggerung einer Aufzeichnung eines mit einem Rauschsignal überlagerten Messsignals,

Fig. 5A, 5B   Tabellen mit Triggerfehlern in Abhängigkeit der Frequenz des Messsignals bei der Vorrichtung zur digitalen Triggerung nach dem Stand der Technik und bei einer erfindungsgemäßen Vorrichtung zu digitalen Triggerung und

Fig. 6   ein Flussdiagramm des erfindungsgemäßen Verfahrens zu digitalen Triggerung einer Aufzeichnung eines mit einem Rauschsignal überlagerten Messsignals.

Die erfindungsgemäße Vorrichtung zur digitalen Triggerung ist in Fig. 4 dargestellt und wird im Folgenden beschrieben.

Das analoge Messsignal mit überlagertem Rauschen wird in einem Analog/Digital-Wandler 1 in sein korrespondierendes digitales Datenformat gewandelt. In einem anschließenden Entzerrungsfilter 2 erfolgt eine Entzerrung des linear bzw. nichtlinear verzerrten digitalisierten Messsignals.

Das Signal am Ausgang des Entzerrungsfilters 2 wird in einer Dezimationseinheit 3 komprimiert, indem nur jeder n-te Abtastwert des Signals am Ausgang des Entzerrungsfilters 2 an die Aufzeichnungseinheit 4 weitergereicht wird. Parallel dazu wird das Signal am Ausgang des Entzerrungsfilters 2 einem Tiefpassfilter 5 zugeführt. Im Tiefpassfilter 5 wird insbesondere das gegenüber dem Messsignal höherfrequente Rauschsignal erfindungsgemäß bandbegrenzt. Auf diese Weise wird die Varianz $\sigma_n^2$ des Rauschsignals reduziert. In einer dem Tiefpassfilter 5 nachfolgenden digitalen Triggereinheit 6 wird das bandbegrenzte Messsignal mit überlagertem Rauschsignal mit einstellbaren Schwellwerten zur Erzeugung eines Triggersignals verglichen.

Das digitale Triggersignal wird einer Aufzeichnungssteuerung 7 innerhalb der Aufzeichnungseinheit 4 zugeführt. In der Aufzeichnungssteuerung 7 werden die z. B. in einem in Fig. 4 nicht dargestellten Ringpuffer zyklisch zwischengespeicherten dezimierten Abtastwerte des mit einem Rauschsignal überlagerten Messsignals hinsichtlich des Triggersignals für die Aufzeichnung selektiert. Die von der Aufzeichnungssteuerung 7 selektierten Abtastwerte des mit einem Rauschsignal überlagerten Messsignals werden in einem nachfolgenden Akquisitionsspeicher 8 der Aufzeichnungseinheit 4 abgelegt und anschließend auf einer Visualisierungseinheit 9 z. B. einem Display, der Aufzeichnungseinheit 4 dargestellt.

Während in der Tabelle der Fig. 5A die Triggerfehler einer Vorrichtung zur digitalen Triggerung nach dem Stand der Technik ohne Tiefpassfilter für unterschiedliche Frequenzen des Messsignals aufgeführt sind, sind in der Tabelle der Fig. 5B die Triggerfehler der erfindungsgemäßen Vorrichtung zur digitalen Triggerung für unterschiedliche Frequenzen des Messsignals enthalten. Wie unschwer zu erkennen ist, reduziert sich der Triggerfehler bei einer erfindungsgemäßen Vorrichtung zur digitalen Triggerung gegenüber einer Vorrichtung zur digitalen Triggerung nach dem Stand der Technik über einen großen Frequenzbereich des Messsignals deutlich.

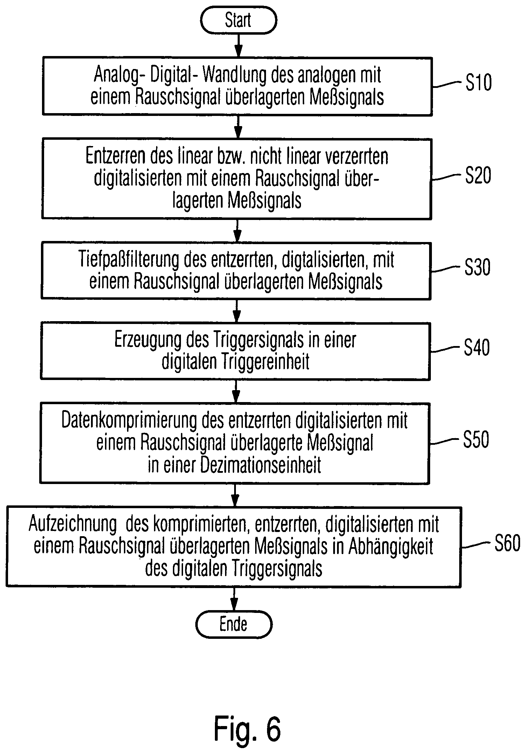

Das erfindungsgemäße Verfahren zur digitalen Triggerung ist in Fig. 6 dargestellt.

In einem ersten Verfahrenschritt S10 wird das mit einem Rauschsignal überlagerte analoge Messsignal in einem Analog-Digital-Wandler 1 in sein korrespondierendes digitales Datenformat gewandelt.

Im nächsten Verfahrenschritt S20 erfolgt eine Entzerrung des u.U. linear bzw. nichtlinear verzerrten digitalisierten mit einem Rauschsignal überlagerten Messsignal.

Im darauf folgenden Verfahrensschritt S30 wird das digitalisierte, entzerrte mit einem Rauschsignal überlagerte Messsignal in einem Tiefpassfilter gefiltert.

Der Verfahrenschritt S40 beinhaltet die Erzeugung des Triggersignals durch Schwellwertvergleich des tiefpassgefilterten, entzerrten, digitalisierten mit einem Rauschsignal überlagerten Messsignals mit einem vorgegebenen Schwellwert in einer digitalen Triggereinheit.

Das entzerrte digitalisierte mit einem Rauschsignal überlagerte Messsignal wird im folgenden Verfahrenschritt S50 in einer Dezimationseinheit komprimiert, indem nur jeder n-te Abtastwert des entzerrten digitalisierten mit einem Rauschsignal überlagerten Messsignal weiterverarbeitet wird.

Schließlich erfolgt im abschließenden Verfahrenschritt S60 die Aufzeichnung des komprimierten, entzerrten, digitalisierten und mit einem Rauschsignal überlagerten Messsignals in Abhängigkeit des digitalen Triggersignals. Hierzu wird das z. B. in einem Ringpuffer zwischengespeicherte mit einem Rauschsignal überlagerte Messsignal in Abhängigkeit des Triggersignals hinsichtlich seiner in einem nachfolgenden Akquisitionsspeicher 8 abzulegenden und in einer darauf folgenden Visualisierungseinheit 9 darzustellenden digitalisierten Signalanteile selektiert. Die Erfindung ist nicht auf das dargestellte Ausführungsbeispiel beschränkt. Insbesondere kann anstelle einer Tiefpassfilterung auch eine Bandpassfilterung mit einer die Bandbreite des mit einem Rauschsignal überlagerten Messsignals reduzierenden Wirkung eingesetzt werden.

## Patentansprüche

1. Vorrichtung zur digitalen Triggerung einer Aufzeichnung eines digitalisierten, mit einem Rauschsignal überlagerten Messsignals mit einer digitalen Aufzeichnungseinheit (4) und mit einer die Aufzeichnung des Messsignals in der Aufzeichnungseinheit (4) triggernden, digitalen Triggereinheit (6), denen jeweils das Messsignal zugeführt ist, und mit einem der digitalen Triggereinheit (6) vorgeschalteten Tiefpassfilter (5) zur Bandbegrenzung des dem Messsignal überlagerten Rauschsignals,
**dadurch gekennzeichnet,**
**dass** die Bandbreite des Tiefpassfilters (5) in Abhängigkeit der Flankensteilheit des Messsignals eingestellt ist, um die Varianz $\sigma_t^2$ des Jitterns des digitalen Triggersignals zu reduzieren.

2. Verfahren zur digitalen Triggerung einer digitalen Aufzeichnung eines digitalisierten, mit einem Rauschsignal überlagerten Messsignals, indem aus dem digitalisierten Messsignal ein digitales Triggersignal zur digitalen Triggerung der digitalen Aufzeichnung des Messsignals erzeugt wird und vor der Erzeugung des digitalen Triggersignals das dem digitalisierten Messsignal überlagerte Rauschsignal über eine Tiefpassfilterung bandbegrenzt wird,
**dadurch gekennzeichnet,**
**dass** die Bandbreite der Tiefpassfilterung in Abhängigkeit der Flankensteilheit des Messsignals eingestellt wird, um die Varianz $\sigma_t^2$ des Jitterns des digitalen Triggersignals zu reduzieren.

## Claims

1. Device for digitally triggering a recording of a digitized measurement signal having a superimposed noise signal, with a digital recording unit (4) and with a digital trigger unit (6) triggering the recording of the measurement signal in the recording unit (4), to each of which the measurement signal is fed, and with a low pass filter (5) connected in front of the digital trigger unit (6) for limiting the band of the noise signal superimposed on the measurement signal,
**characterised in that**
the bandwidth of the low pass filter (5) is set depending on the edge steepness of the measurement signal in order to reduce the variance $\sigma_t^2$ of the jitter of the digital trigger signal.

2. Method for digitally triggering a digital recording of a digitized measurement signal having a superimposed noise signal in which a digital trigger signal is generated from the digitized measurement signal for digitally triggering the digital recording of the measurement signal and before the generation of the digital trigger signal the band of the noise signal superimposed on the digitized measurement signal is limited by means of a low pass filter,
**characterised in that**
the band width of the low pass filter is set depending on the edge steepness of the measurement signal in order to reduce the variance $\sigma_t^2$ of the jitter of the digital trigger signal.

**Revendications**

1. Dispositif de déclenchement numérique d'un enregistrement d'un signal de mesure numérisé à signal de bruit superposé, comprenant une unité d'enregistrement numérique (4) et une unité de déclenchement numérique (6) déclenchant l'enregistrement du signal de mesure dans l'unité d'enregistrement (4) et à laquelle le signal de mesure est amené dans chaque cas, et un filtre passe-bas (5) monté en amont de l'unité de déclenchement numérique (6) pour limiter en largeur de bande le signal de bruit superposé sur le signal de mesure,
**caractérisé en ce que**
la largeur de bande du filtre passe-bas (5) est réglée en fonction de la pente du signal de mesure, afin de réduire la variance $\sigma_t^2$ de la guigue du signal de déclenchement numérique.

2. Procédé de déclenchement numérique d'un enregistrement numérique d'un signal de mesure numérisé à signal de bruit superposé, selon lequel un signal de déclenchement numérique est produit à partir du signal de mesure numérisé pour le déclenchement numérique de l'enregistrement numérique du signal de mesure et, avant la production du signal de mesure numérique, le signal de bruit superposé sur le signal de mesure numérisé est limité en largeur de bande par un filtrage passe-bas,
**caractérisé en ce que**
la largeur de bande du filtrage passe-bas est réglée en fonction de la pente du signal de mesure, afin de réduire la variance $\sigma_t^2$ de la guigue du signal de déclenchement numérique.

Fig. 1

Fig. 2A

Fig. 2B

| Frequenz des Signals in MHz | SNR in dB | | | |
|---|---|---|---|---|
| | 30 | 40 | 50 | 60 |
| 1 | 5032,92 ps | 1591,55 ps | 503,29 ps | 159,15 ps |
| 10 | 503,29 ps | 159,15 ps | 50,33 ps | 15,92 ps |
| 100 | 50,33 ps | 15,92 ps | 5,03 ps | 1,59 ps |
| 1000 | 5,03 ps | 1,59 ps | 0,50 ps | 0,16 ps |

## Fig. 3

## Fig. 4

| | Frequenz des Sinussignals | | | |
|---|---|---|---|---|
| | 1 MHz | 10 MHz | 100 MHz | 1 GHz |
| Triggerfehler | 5,03 ns | 503 ps | 50,3 ps | 5,03 ps |

## Fig. 5A

| | Frequenz des Sinussignals | | | |
|---|---|---|---|---|
| | 1 MHz | 10 MHz | 100 MHz | 1 GHz |
| Triggerfehler | 159,1 ps | 50,3 ps | 15,9 ps | 5,03 ps |

## Fig. 5B

Start

Analog- Digital- Wandlung des analogen mit
einem Rauschsignal überlagerten Meßsignals — S10

Entzerren des linear bzw. nicht linear verzerrten
digitalisierten mit einem Rauschsignal überlagerten Meßsignals — S20

Tiefpaßfilterung des entzerrten, digtalisierten, mit
einem Rauschsignal überlagerten Meßsignals — S30

Erzeugung des Triggersignals in einer
digitalen Triggereinheit — S40

Datenkomprimierung des entzerrten digitalisierten mit
einem Rauschsignal überlagerte Meßsignal
in einer Dezimationseinheit — S50

Aufzeichnung des komprimierten, entzerrten, digitalisierten mit
einem Rauschsignal überlagerten Meßsignals in Abhängigkeit
des digitalen Triggersignals — S60

Ende

# Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060074607 A1, WELLER DENNIS J
- DE 3418500 A1